# EUROPÄISCHE PATENTANMELDUNG

(11) **EP 4 231 489 A1**
(43) Veröffentlichungstag der Anmeldung: **23.08.2023**
(21) Anmeldenummer: 23155556.6
(22) Anmeldetag: 08.02.2023
(51) Int. Cl.: H02J 7/00, B25F 5/02, H01M 10/42, H01M 10/6235

(54) **IDENTIFIKATION, KONFIGURATION UND STEUERUNG EINES ELEKTROGERÄTS**

(30) Priorität: 21.02.2022 DE 102022104039
(71) Anmelder: Einhell Germany AG, 94405 Landau / Isar (DE)
(72) Erfinder: THANNHUBER, Dr. Markus, 94405 Landau/Isar (DE)
(74) Vertreter: Hofstetter, Schurack & Partner

(57) **Zusammenfassung**

Gemäß einem Verfahren zur Steuerung eines ersten Elektrogeräts (4) mittels eines Akkupacks (1), das wahlweise mit dem ersten Elektrogerät (4) und wenigstens einem zweiten Elektrogerät verbindbar ist, wird eine generische Software zur Steuerung des ersten Elektrogeräts (4) und des wenigstens einen zweiten Elektrogeräts auf einem Speicherelement des Akkupacks (1) gespeichert. Identifikationsinformationen, welche das erste Elektrogerät (4) identifizieren, werden von dem Akkupack (1) erhalten und abhängig von den Identifikationsinformationen werden mittels des Akkupacks (1) Konfigurationsinformationen von einem externen Computersystem (10) angefordert und erhalten. Die Software wird gemäß den Konfigurationsinformationen konfiguriert und das erste Elektrogerät (4) wird mittels des Akkupacks (1) durch Ausführung der konfigurierten Software gesteuert.

## Beschreibung

Die vorliegende Erfindung betrifft ein Verfahren zur Steuerung eines ersten Elektrogeräts mittels eines Akkupacks, das wahlweise mit dem ersten Elektrogerät und wenigstens einem zweiten Elektrogerät verbindbar ist. Des Weiteren ist die Erfindung auf ein entsprechendes Akkupack gerichtet.

Die Vernetzung physischer Geräte und virtueller Objekte miteinander sowie deren Zusammenarbeit anhand von Informations- und Kommunikationstechniken, auch bekannt unter Begriffen wie "Internet der Dinge" oder "Internet of Things", IoT, ist in zunehmendem Maße Teil des privaten und öffentlichen Alltags. Dadurch können die Geräte und Systeme zum einen selbst untereinander interagieren, zum anderen auch mit menschlichen Benutzern. Beispiele zur Anwendung reichen von Daheimautomatisierung über die Sicherheitstechnik, die prädiktive Wartung von Maschinen bis hin zu den Lebenswissenschaften.

Ein weiteres Beispiel ist die cloudbasierte Steuerung und Überwachung von Elektrogeräten, wie etwa Elektrowerkzeugen, Haushaltsgeräten oder Gartengeräten. So kann beispielsweise eine Bewässerungspumpe gemäß einem erlernten Bewässerungsverhalten abhängig vom Temperaturverlauf, Niederschlägen, Bewölkung und Bodenbeschaffenheit automatisch eine Fläche optimal bewässern. Außerdem ist es möglich, durch projektabhängige Interaktion eines Cloud-Computersystems mit dem Elektrogerät oder dessen Akkupack eine projektabhängige Benutzerunterstützung, eine projektabhängige Parametrierung des Elektrowerkzeugs, eine projektabhängige Verschleißabschätzung von Verschleißteilen des Elektrowerkzeugs und so weiter zu realisieren. Auch ein gekoppelter Betrieb mehrerer Elektrogeräte ist möglich.

Bei der Entwicklung IoT-fähiger Elektrogeräte führt die individuelle Programmierung und Anpassung des Elektrogeräts und/oder des Akkupacks zu einem erhöhten Aufwand. So ist es beispielsweise erforderlich, die Elektronik, welche das Elektrowerkzeug steuert, beispielsweise über eine Pulsweitenmodulation, PWM, der Leistungs- oder Stromabgabe vom Akkupack zum Elektrogerät, nicht nur prinzipiell über eine Firmware zu befähigen, beispielsweise einen elektrischen Verbraucher des Elektrogeräts, etwa einen Motor, anzusteuern, sondern auch die erforderlichen Informationen bereitzustellen, wie die Steuerung im Einzelnen erfolgen kann und soll, basierend auf welchen Messwerten, Grenzwerten, Parametern oder Modellen die Steuerung durchgeführt wird und so weiter. Darüber hinaus ist es wünschenswert, Elektrogeräte, die nativ gegebenenfalls nicht IoT-fähig sind, durch eine entsprechende Nachrüstung oder dergleichen dazu zu befähigen.

Es ist eine Aufgabe der vorliegenden Erfindung, ein generisches Akkupack in einfacher und flexibler Weise zur Steuerung eines konkreten Elektrogeräts zu befähigen.

Diese Aufgabe wird durch den jeweiligen Gegenstand der unabhängigen Ansprüche gelöst. Vorteilhafte Weiterbildungen und bevorzugte Ausführungsformen sind Gegenstand der abhängigen Ansprüche.

Die Erfindung beruht auf dem Gedanken, das Akkupack für das Elektrogerät zunächst mit einer generischen Software zur Steuerung unterschiedlicher Elektrogeräte auszustatten, sodann das konkrete Elektrogerät zu identifizieren und basierend auf der Identifikation mittels des Akkupacks Konfigurationsinformationen zur spezifischen Konfiguration der Software von einem externen Computersystem anzufordern und zu erhalten.

Gemäß einem Aspekt der Erfindung wird ein Verfahren zur Steuerung eines ersten Elektrogeräts mittels eines Akkupacks angegeben. Dabei kann das Akkupack, insbesondere zur Energieversorgung, wahlweise mit dem ersten Elektrogerät und wenigstens einem zweiten Elektrogerät, insbesondere elektrisch und mechanisch, verbunden werden. Es wird eine generische Software zur Steuerung des ersten Elektrogeräts und des wenigstens einen zweiten Elektrogeräts auf einem Speicherelement des Akkupacks gespeichert. Identifikationsinformationen, welche das erste Elektrogerät identifizieren, werden von dem Akkupack, beispielsweise einem Verarbeitungsschaltkreis des Akkupacks, erhalten. Abhängig von den Identifikationsinformationen werden mittels des Akkupacks, insbesondere über eine erste Kommunikationsschnittstelle des Akkupacks, Konfigurationsinformationen, insbesondere drahtlos, von einem externen Computersystem angefordert und erhalten und insbesondere gespeichert, beispielsweise auf dem Speicherelement des Akkupacks oder einem weiteren Speicherelement des Akkupacks. Die generische Software wird, insbesondere mittels des Akkupacks, beispielsweise mittels des Verarbeitungsschaltkreises, gemäß den erhaltenen Konfigurationsinformationen konfiguriert. Das erste Elektrogerät wird mittels des Akkupacks durch Ausführung der konfigurierten Software gesteuert, insbesondere über eine zweite Kommunikationsschnittstelle des Akkupacks.

Dass es sich bei der Software um eine generische Software zur Steuerung des ersten Elektrogeräts sowie des wenigstens einen zweiten Elektrogeräts handelt, kann insbesondere derart verstanden werden, dass sich die Software, insbesondere nach einer entsprechenden spezifischen Konfiguration, prinzipiell sowohl zur Steuerung des ersten Elektrogeräts als auch zur Steuerung des wenigstens einen zweiten Elektrogeräts eignet, insbesondere wenn das Akkupack mit dem ersten Elektrogerät beziehungsweise dem entsprechenden zweiten Elektrogerät mechanisch und elektrisch verbunden ist. Je nachdem, welches konkrete Elektrogerät tatsächlich durch das Akkupack und die Software gesteuert werden soll, sind gegebenenfalls unterschiedliche Konfigurationsinformationen erforderlich beziehungsweise ist eine unterschiedliche Konfiguration der zunächst generischen Software erforderlich. Insbesondere kann es sein, dass die generische Software vor einer entsprechenden Konfiguration nicht zur Steuerung des ersten und/oder eines zweiten Elektrogeräts einsatzfähig ist. Erst nachdem die der Software durch Konfiguration von der generischen Software eine spezifisch angepasste Software geworden ist, ist dann beispielsweise eine solche Steuerung möglich. Im erfindungsgemäßen Verfahren ist die Software also so lange eine generische Software, bis sie gemäß den Konfigurationsinformationen konfiguriert wurde. Die konfigurierte Software ist dann nicht mehr generisch und ist insbesondere zur Steuerung des ersten Elektrogeräts geeignet, aber nicht notwendigerweise zur Steuerung eines der zweiten Elektrogeräte.

Entsprechendes lässt sich analog auf das Akkupack selbst übertragen. Das Akkupack ist also insbesondere ein generisches Akkupack zur Steuerung des ersten Elektrogeräts und des wenigstens einen zweiten Elektrogeräts, solange die Software nicht konfiguriert wurde. Danach handelt es sich um ein konfiguriertes oder spezifisch angepasstes Akkupack.

Mit anderen Worten sind die Konfigurationsinformationen dem ersten Elektrogerät zugeordnet, insbesondere individuell zugeordnet, wobei die Zuordnung insbesondere über die Identifikationsinformationen erfolgt. Die Speicherung der generischen Software auf dem Akkupack kann also beispielsweise während der Produktion oder am Ende der Produktion des Akkupacks erfolgen, bevor das Akkupack an einen Benutzer ausgeliefert wird. Steht dann fest, mit welchem Elektrogerät das Akkupack konkret verwendet wird, ist also das erste Elektrogerät definiert, so wird erfindungsgemäß das erste Elektrogerät durch das Akkupack identifiziert, indem das Akkupack die Identifikationsinformationen erhält.

Die Konfigurationsinformationen können dann abhängig von den Identifikationsinformationen zentral von dem externen Computersystem abgerufen werden und zur Konfiguration der konkreten Software auf dem Akkupack auf das Akkupack geladen werden.

Ist die Konfiguration der Software gemäß den Konfigurationsinformationen durchgeführt worden, so kann das erste Elektrogerät dementsprechend mittels des Akkupacks gesteuert werden, insbesondere kann dann ein elektrischer Verbraucher des Elektrogeräts, beispielsweise ein Motor, in geeigneter Weise durch das Akkupack angesteuert werden. Zur Steuerung des ersten Elektrogeräts mittels des Akkupacks, insbesondere in Betrieb, ist dabei insbesondere keine Kommunikation des Elektrogeräts mit dem externen Computersystem erforderlich.

Bei der generischen Software kann es sich also beispielsweise um eine Firmware handeln, also um eine Software, die insbesondere funktional fest mit einer Hardware des Akkupacks verbunden ist, sodass das Akkupack ohne die Software nicht nutzbar ist, jedenfalls nicht zur Steuerung des ersten Elektrogeräts oder des wenigstens einen zweiten Elektrogeräts nutzbar ist, und die Software auch ohne das Akkupack beziehungsweise die Hardware des Akkupacks nicht nutzbar ist. Das Speicherelement, das beispielsweise als programmierbarer Speicher ausgestaltet sein kann, und damit die Software sind insbesondere Bestandteil des Verarbeitungsschaltkreises. Das Speicherelement kann beispielsweise als Flash-Speicher, EPROM, EEPROM oder ROM ausgestaltet sein oder als nicht persistentes Speicherelement, beispielsweise RAM.

Bei einem Elektrogerät kann es sich hier und im Folgenden zum Beispiel um ein Elektrowerkzeug, ein elektrisches oder elektronisches Haushaltsgerät, ein elektrisches oder elektronisches Gartengerät, ein elektrisch angetriebenes Fahrzeug, insbesondere Kleinfahrzeug, beispielsweise einen Elektrotretroller oder ein Elektrofahrrad, und so weiter handeln.

Das erste Elektrogerät und das wenigstens eine zweite Elektrogerät unterscheiden sich insbesondere voneinander. Die Unterschiede zwischen dem ersten Elektrogerät und dem wenigstens einen zweiten Elektrogerät können dabei fundamentaler Natur sein, es kann sich also um vollständig unterschiedliche Arten von Elektrogeräten handeln, beispielsweise um einen Schrauber einerseits und einen Rasenmäher andererseits. Das erste und das wenigstens eine zweite Elektrogerät können sich aber auch in weniger grundlegenden Eigenschaften, wie beispielsweise einer maximalen Leistungsaufnahme, einer Spezifikation des konkreten elektrischen Verbrauchers oder bestimmten ausführbaren Funktionen unterscheiden. Beispielsweise kann es sich sowohl bei dem ersten Elektrogerät als auch bei dem wenigstens einen zweiten Elektrogerät um Schlagbohrmaschinen handeln, wobei das erste Elektrogerät mit einer anderen Betriebsspannung zu versorgen ist, als das zweite Elektrogerät. Diese konkreten Beispiele sind selbstverständlich nur zur Veranschaulichung gedacht und schränken die Erfindung in keiner Weise ein.

Das Speichern der generischen Software auf dem Speicherelement des Akkupacks kann unabhängig davon erfolgen, ob das Akkupack mit dem ersten Elektrogerät elektrisch oder mechanisch verbunden ist oder sich in der unmittelbaren oder weiteren Umgebung des ersten Elektrogeräts befindet oder nicht. Je nach Ausführungsform können die Identifikationsinformationen dem Akkupack auf unterschiedliche Weise bereitgestellt werden. Dementsprechend kann auch das Erhalten der Identifikationsinformationen durch das Akkupack in verschiedenen Ausführungsformen erfolgen, wenn das Akkupack nicht beziehungsweise noch nicht elektrisch und/oder mit dem ersten Elektrogerät mechanisch verbunden ist. Dies gilt dementsprechend auch für das Anfordern und Erhalten der Konfigurationsinformationen und die Konfiguration der Software. Bevor das erste Elektrogerät durch das Akkupack gesteuert wird, wird das Akkupack jedoch mit dem ersten Elektrogerät verbunden, insbesondere mechanisch und elektrisch.

Das externe Computersystem wird als extern bezeichnet, da es insbesondere extern zu dem Elektrogerät und extern zu dem Akkupack angeordnet ist und insbesondere mit diesen nicht mechanisch oder elektrisch verbunden ist. Das externe Computersystem kann einen oder mehrere Servercomputer, auch als Cloudcomputer bezeichnet, beinhalten oder einen physischen und/oder virtuellen Verbund von Servercomputern und/oder sonstigen externen Recheneinheiten. Das externe Computersystem kann alternativ oder zusätzlich eines oder mehrere mobile elektronische Geräte, wie etwa Mobiltelefone, Smartphones, Tabletcomputer, Notebookcomputer und so weiter, und/oder stationäre Recheneinheiten, wie etwa Personal Computer, PC, beinhalten.

Vorzugsweise werden die Konfigurationsinformationen mittels des Akkupacks drahtlos von dem externen Computersystem angefordert und erhalten. Die drahtlose Kommunikation zwischen dem Akkupack und dem externen Computersystem kann beispielsweise über ein Funknetzwerk, etwa ein Mobilfunknetz, ein WLAN-Netz oder ein Niedrigenergieweitverkehrnetz, LPWAN (englisch: "Low Power Wide Area Network"), insbesondere ein NB-IoT-Netzwerk (englisch: "Narrowband Internet of Things") erfolgen. Das Funknetz kann insbesondere gemäß GSM, UMTS, LTE, 5G, 6G und so weiter oder NB-IoT ausgestaltet sein. Ferner sind auch nicht-zellbasierte Ansätze, wie etwa LoRa, ZigBee oder Sigfox möglich.

Die Identifikationsinformationen erlauben es, das konkrete erste Elektrogerät oder den Typ des ersten Elektrogeräts zu identifizieren. Es kann also durch die Identifikationsinformationen eine Identifizierung genau eines einzigen Elektrogeräts möglich sein oder lediglich eine Identifikation gleichartig konstruierter und/oder eingerichteter Elektrogeräte. Jedenfalls können alle Elektrogeräte, die durch die Identifikationsinformationen definiert sind und denen dementsprechend dieselben Konfigurationsinformationen zugeordnet sind, durch die dementsprechend konfigurierte Software gesteuert werden.

Der Verarbeitungsschaltkreis kann die Identifikationsinformationen je nach Ausgestaltungsform des Akkupacks und/oder des Elektrogeräts auf unterschiedliche Arten erhalten. Beispielsweise kann das Akkupack ein Erfassungsgerät, beispielsweise ein Lesegerät zum Lesen visueller Informationen oder elektronisch gespeicherter Informationen, beispielsweise mittels RFID-Technologie (englisch: "Radio-frequency Identification") aufweisen, um die Identifikationsinformationen zu erhalten beziehungsweise zu erfassen und an den Verarbeitungsschaltkreis zu übermitteln.

Alternativ oder zusätzlich kann der Verarbeitungsschaltkreis die Identifikationsinformationen in elektronischer, insbesondere digitaler, Form über die zweite Kommunikationsschnittstelle von dem Elektrogerät erhalten, wenn eine Kommunikationsverbindung zwischen dem Elektrogerät und der zweiten Kommunikationsschnittstelle des Akkupacks hergestellt ist oder über eine weitere Kommunikationsschnittstelle des Akkupacks zum Datenaustausch mit dem ersten Elektrogerät. Die Kommunikationsverbindung kann in manchen Ausführungsformen drahtlos sein. Alternativ oder zusätzlich kann der Verarbeitungsschaltkreis die Identifikationsinformationen auch über eine mechanische und elektrische Verbindung des Akkupacks mit dem ersten Elektrogerät erhalten, beispielsweise über einen digitalen Bitcode, der über entsprechende Kontakte übermittelt wird, oder über die Auswertung spezifischer Spannungs- und/oder Widerstandswerte an solchen Kontakten.

Alternativ kann auch eine verbindungslose Kommunikation zwischen dem Verarbeitungsschaltkreis beziehungsweise der weiteren Kommunikationsschnittstelle des Akkupacks und dem ersten Elektrogerät, beispielsweise mittels Bluetooth oder einem sonstigen Rundfunk- beziehungsweise Broadcastsignal, erfolgen.

Alternativ oder zusätzlich kann der Verarbeitungsschaltkreis die Identifikationsinformationen über eine mechanische Codierung erhalten. Beispielsweise kann an einer mechanischen Verbindungsstelle des ersten Elektrowerkzeugs zur Verbindung mit dem Akkupack, etwa einem entsprechenden Schuh, ein Raster codiert sein, das abgetastet werden kann und die Identifikationsinformationen enthält.

Zusammenfassend kann der Verarbeitungsschaltkreis die Identifikationsinformationen insbesondere über das Erfassungsgerät des Akkupacks, über die zweite Kommunikationsschnittstelle oder über die weitere Kommunikationsschnittstelle des Akkupacks zum Datenaustausch mit dem ersten Elektrogerät erhalten.

Die Konfigurationsinformationen sind den Identifikationsinformationen und damit dem ersten Elektrogerät oder gleichartigen Elektrogeräten zugeordnet. Die Zuordnung kann vorgegeben sein, sie kann insbesondere auf dem externen Computersystem gespeichert sein. Die Konfigurationsinformationen enthalten insbesondere Informationen dahingehend, wie bestimmte Steuerungsvorgänge zur Steuerung des ersten Elektrogeräts durch das Akkupack koordiniert und/oder durchgeführt werden können. Bei den Steuerungsvorgängen kann es sich dabei um relativ einfache generische Steuerungsvorgänge zur Steuerung des Verbrauchers des Elektrogeräts handeln, wie etwa ein Betrieb des Verbrauchers bei einer konstanten Stromaufnahme, einer konstanten Motordrehzahl, einem konstanten Motordrehmoment, einem bestimmten vordefinierten Drehmomentprofil, einem bestimmten vordefinierten Drehzahlprofil und so weiter. Die Steuerungsvorgänge können aber auch komplexere Vorgänge beinhalten, beispielsweise durch Kombination mehrerer generischer Steuerungsvorgänge in einer vordefinierten Weise.

Die Konfigurationsinformationen können auch Modelle oder Informationen über Modelle zur Alterung oder Steuerung oder zum elektromechanischen oder physikalischen Verhalten des Elektrogeräts oder des Verbrauchers beinhalten, die das Akkupack zur Steuerung des ersten Elektrogeräts verwenden kann. Die Konfigurationsinformationen können auch Grenzwerte für bestimmte Parameter, also Parameterbereiche, beispielsweise betreffend Parameter zur Pulsweitenmodulation oder zur Stromabgabe oder zur Leistungsabgabe oder zur Auswertung sonstiger Sensoren, wie etwa Temperatursensoren, Temperaturbereiche, Temperaturgrenzwerte und so weiter beinhalten. Die Konfigurationsinformationen können auch Informationen dahingehend beinhalten, wie das Akkupack aus der Stromaufnahme oder Leistungsaufnahme oder Spannungsaufnahme des Verbrauchers, beispielsweise anhand sogenannter Ripples, auf Zustandseigenschaften des Elektrogeräts, des Akkupacks und/oder des Verbrauchers des Elektrogeräts schließen kann. Die Konfigurationsinformationen können auch Informationen zur Kommunikation des ersten Elektrogeräts mit einem weiteren Elektrogerät, beispielsweise dem wenigstens einen zweiten Elektrogerät oder einem dritten Elektrogerät, beinhalten und/oder Informationen zur Kommunikation des Akkupacks mit einem weiteren Akkupack. Auf diese Weise kann beispielsweise ein gekoppelter Betrieb mehrerer Akkupacks und/oder Elektrogeräte koordiniert und durchgeführt werden.

Es sei darauf hingewiesen, dass die Steuerung des ersten Elektrogeräts nicht notwendigerweise ausschließlich über das Akkupack erfolgen muss. Dies kann zwar der Fall sein, es kann jedoch auch sein, dass das erste Elektrogerät über eine eigene Elektronik oder Hardware und/oder Software, beispielsweise Firmware, zur Steuerung bestimmter Funktionen oder grundlegender Abläufe verfügt.

Erfindungsgemäß kann also ein universell nutzbares Akkupack, also insbesondere ein wahlweise zur Steuerung des ersten Elektrogeräts als auch des wenigstens einen zweiten Elektrogeräts geeignetes Akkupack, weitgehend unabhängig von der konkreten Ausgestaltung des ersten Elektrogeräts und unabhängig von dessen konkreten Erfordernissen hinsichtlich der Steuerung durch das Akkupack gesteuert werden. Dies wird erreicht, indem das Akkupack, insbesondere die generische Software, erst dann basierend auf den entsprechenden Konfigurationsinformationen konfiguriert wird, wenn definiert ist beziehungsweise feststeht, um welches Elektrogerät es sich bei dem ersten Elektrogerät konkret handelt, was also die Identifikationsinformationen des ersten Elektrogeräts sind.

Das Akkupack kann dementsprechend für beliebige kompatible Elektrogeräte, inklusive des ersten Elektrogeräts und des wenigstens einen zweiten Elektrogeräts, verwendet werden. Das Akkupack kann neben der Steuerung des ersten Elektrogeräts, alleine oder in Kombination mit einem oder mehreren weiteren Akkupacks, auch zur Energieversorgung des ersten Elektrogeräts, insbesondere des elektrischen Verbrauchers des ersten Elektrogeräts, dienen. Dazu weist das Akkupack insbesondere wenigstens eine Akkumulatorzelle auf, beispielsweise wenigstens eine lithiumbasierte Akkumulatorzelle. Die Kombination der Steuerungsfunktionalität mit der Energieversorgung des ersten Elektrogeräts in dem Akkupack ist besonders vorteilhaft, da die wenigstens eine Akkumulatorzelle des Akkupacks dadurch auch zur Energieversorgung des Verarbeitungsschaltkreises und zur Energieversorgung zur Kommunikation des Akkupacks mit dem externen Computersystem eingesetzt werden kann, ohne dass dazu eine zusätzliche Energiequelle nötig wäre.

Das Akkupack kann lösbar, insbesondere zerstörungsfrei lösbar, mit einem Gehäuse des ersten Elektrogeräts verbunden werden, beispielsweise über eine Rastverbindung, eine Steckverbindung und/oder eine Klemmverbindung. Insbesondere kann die mechanische Verbindung des Akkupacks mit dem Gehäuse des ersten Elektrogeräts als formschlüssige und/oder kraftschlüssige Verbindung ausgestaltet sein, ohne dass eine stoffschlüssige Verbindung vorliegt. Mit anderen Worten kann die mechanische Verbindung des Akkupacks mit dem Gehäuse des ersten Elektrogeräts gelöst werden, ohne dass eine stoffschlüssige Verbindung zu lösen ist. Vorzugsweise kann die mechanische Verbindung bestimmungsgemäß manuell ohne den Einsatz sonstiger Werkzeuge gelöst werden. Mit anderen Worten ist das Akkupack als Wechselakkupack, insbesondere Systemakkupack, ausgestaltet. Zur elektrischen und mechanischen Verbindung können die Gehäuse des Akkupacks und des ersten Elektrogeräts jeweilige Schnittstellen aufweisen, wobei die entsprechende Schnittstelle des Akkupacks mit der zweiten Kommunikationsschnittstelle kombiniert sein kann.

Eine elektrische Verbindung der wenigstens einen Akkumulatorzelle mit dem ersten Elektrogerät, insbesondere dem Verbraucher des ersten Elektrogeräts, beispielsweise einem Motor des ersten Elektrogeräts, kann beispielsweise über einen oder mehrere lösbare elektrische Kontakte, beispielsweise Klemmkontakte oder Steckkontakte, insbesondere sogenannte Tulpenkontakte oder Schwertkontakte, erfolgen. Beispielsweise können an den Schnittstellen der entsprechenden Gehäuse jeweils zueinander kompatible Stecker oder Buchsen beziehungsweise Aufnahmen oder dergleichen vorgesehen sein, um die elektrische Verbindung des Akkupacks mit dem Elektrogerät zu erzielen. Dabei können die lösbaren elektrischen Kontakte auf Seiten des Akkupacks Teil der zweiten Kommunikationsschnittstelle sein oder separat dazu vorgesehen sein.

Die Ausführungen bezüglich der mechanischen und/oder elektrischen Verbindung des Akkupacks mit dem ersten Elektrogerät lassen sich analog auf die elektrische und/oder mechanische Verbindung des Akkupacks mit dem wenigstens einen zweiten Elektrogerät übertragen. Beispielsweise kann ein entsprechendes Gehäuse des wenigstens einen zweiten Elektrogeräts in dieser Hinsicht identisch oder weitgehend identisch zu dem Gehäuse des ersten Elektrogeräts ausgestaltet sein.

Gemäß zumindest einer Ausführungsform des Verfahrens beinhaltet die Steuerung des ersten Elektrogeräts mittels des Akkupacks eine Steuerung eines von dem Akkupack, insbesondere von der wenigstens einen Akkumulatorzelle, an das erste Elektrogerät, insbesondere an den elektrischen Verbraucher, abgegebenen Stroms und/oder einer von dem Akkupack, insbesondere der wenigstens einen Akkumulatorzelle, an das erste Elektrogerät, insbesondere den Verbraucher, abgegebenen elektrischen Leistung. Die Steuerung des Stroms und/oder der Leistung kann dabei beispielsweise basierend auf einer PWM-Steuerung erfolgen.

Gemäß zumindest einer Ausführungsform wird zur Steuerung des Stroms und/oder der elektrischen Leistung wenigstens ein elektronisches Schaltelement des Akkupacks, welches einen Stromfluss von dem Akkupack, insbesondere der wenigstens einen Akkumulatorzelle, zu dem ersten Elektrogerät wahlweise herstellen und unterbrechen kann, gesteuert.

Das wenigstens eine elektronische Schaltelement kann dabei insbesondere wenigstens einen Transistor, beispielsweise Leistungstransistor, insbesondere Feldeffekttransistor, beispielsweise Leistungs-Feldeffekttransistor, beinhalten.

Zusätzlich zur Steuerung des wenigstens einen elektronischen Schaltelements kann die Steuerung des Stroms und/oder der elektrischen Leistung in manchen Ausführungsformen auch das wahlweise Zuschalten beziehungsweise Ankoppeln und Abschalten beziehungsweise Abkoppeln eines oder mehrerer kapazitiver Energiespeicher und/oder eines oder mehrerer induktiver Energiespeicher zu der wenigstens einen Akkumulatorzelle beziehungsweise von der wenigstens einen Akkumulatorzelle beinhalten. Auf diese Weise kann zum Beispiel die an das erste Elektrogerät abgegebene Leistung oder die dem ersten Elektrogerät bereitgestellte Spannung individuell begrenzt werden, beispielsweise bei der PWM-Steuerung.

In verschiedenen Ausführungsformen kann die Steuerung des ersten Elektrogeräts mittels des Akkupacks auch eine Steuerung eines oder mehrerer sonstiger Aktuatoren des Akkupacks und/oder des ersten Elektrogeräts beinhalten.

Gemäß zumindest einer Ausführungsform wird mittels der konfigurierten Software eine Laufzeitumgebung (englisch: "Runtime environment") erzeugt und das erste Elektrogerät wird mittels des Akkupacks durch die Laufzeitumgebung gesteuert.

Gemäß zumindest einer Ausführungsform werden nach der Konfiguration der Software gemäß den Konfigurationsinformationen weitere Konfigurationsinformationen mittels des externen Computersystems an das Akkupack, insbesondere den Verarbeitungsschaltkreis, übermittelt, insbesondere drahtlos. Die Konfiguration der Software wird, insbesondere mittels des Verarbeitungsschaltkreises, gemäß den weiteren Konfigurationsinformationen geändert.

Mit anderen Worten kann die Konfiguration der Software beziehungsweise Firmware so geändert oder aktualisiert werden, beispielsweise mittels OTA (englisch: "Over the air"), ohne die Software oder Firmware vollständig neu installieren zu müssen.

Gemäß zumindest einer Ausführungsform wird das erste Elektrogerät in einem räumlichen Erfassungsbereich eines Lesegeräts, beispielsweise eines Lesegeräts des Akkupacks oder eines extern zu dem Akkupack bereitgestellten Lesegeräts, positioniert. Die Identifikationsinformationen werden mittels des Lesegeräts, insbesondere wenn das erste Elektrogerät in dem Erfassungsbereich positioniert ist, erfasst und insbesondere an den Verarbeitungsschaltkreis übermittelt.

Bei dem Lesegerät kann es sich um ein Lesegerät zum Lesen visueller oder optischer Informationen, beispielsweise einen Barcodescanner oder dergleichen, handeln oder um ein Lesegerät zum drahtlosen oder drahtgebundenen Lesen elektronischer oder digitaler Informationen, beispielsweise mittels RFID. Dementsprechend kann der Erfassungsbereich des Lesegeräts räumlich mehr oder weniger ausgedehnt sein. Um das erste Elektrogerät in den Erfassungsbereich des Lesegeräts zu bringen, kann das Akkupack in manchen Ausführungsformen mechanisch und/oder elektrisch mit dem ersten Elektrogerät verbunden werden. Dies ist jedoch nicht notwendigerweise der Fall, da die Identifikationsinformationen, beispielsweise anhand eines visuell lesbaren Codes oder eines RFID-Transponders, auch an einer anderen Stelle des ersten Elektrogeräts mit dem Akkupack ausgetauscht werden kann, als zur Verbindung des Akkupacks mit dem ersten Elektrogerät vorgesehen ist.

Gemäß zumindest einer Ausführungsform werden die Identifikationsinformationen mittels des Lesegeräts per Radiofrequenz-Identifikation, RFID, von einem RFID-Transponder des ersten Elektrogeräts erhalten.

Mit anderen Worten ist das Lesegerät des Akkupacks als RFID-Lesegerät ausgestaltet. Das RFID-Lesegerät ist mit dem Verarbeitungsschaltkreis beispielsweise verbunden und dazu eingerichtet, die Identifikationsinformationen von dem RFID-Transponder zu erhalten und an den Verarbeitungsschaltkreis zu übermitteln.

Auf diese Weise kann insbesondere eine kontaktlose Übertragung der Identifikationsinformationen erzielt werden, was beispielsweise vorteilhaft ist, wenn die zweite Kommunikationsschnittstelle drahtlos ausgestaltet ist. Zudem kann der RFID-Transponder, der auch als RFID-Tag bezeichnet wird, ohne weiteres ausgetauscht oder nachträglich angebracht werden.

Auch falls das Akkupack mit dem ersten Elektrogerät mechanisch verbunden wird, kann die Übermittlung der Identifikationsinformationen mittels RFID vorteilhaft sein, da der RFID-Transponder flexibel an beliebigen Positionen des Elektrogeräts angeordnet werden kann, sodass das Akkupack beispielsweise vor Anbringen an dem ersten Elektrogerät die Identifikationsinformationen erhalten kann. Auch im Hinblick auf eine Nachrüstbarkeit der IoT-Funktionalität sind RFID-basierte Lösungen vorteilhaft.

Gemäß zumindest einer Ausführungsform wird mittels des Lesegeräts ein visuell lesbarer Code des ersten Elektrogeräts gelesen und, insbesondere mittels des Verarbeitungsschaltkreises, werden die Identifikationsinformationen basierend auf dem gelesenen visuell lesbaren Code bestimmt. Das Lesegerät des Akkupacks ist also insbesondere als optisches Lesegerät ausgebildet, das mit dem Verarbeitungsschaltkreis verbunden ist und dazu eingerichtet ist, den visuell lesbaren Code zu lesen.

Der visuell lesbare Code kann beispielsweise als Strichcode, Barcode, zweidimensionaler QR-Code oder dergleichen oder auch in Form einer Zeichenfolge oder dergleichen gegeben sein. Das optische Lesegerät kann beispielsweise als Barcodescanner oder QR-Scanner oder Kameramodul des Akkupacks ausgestaltet sein.

Alternativ kann das optische Lesegerät auch extern zu dem Akkupack vorgesehen sein, beispielsweise in einem mobilen elektronischen Endgerät, wie etwa einem Mobiltelefon. Das optische Lesegerät kann dann beispielsweise eine Kamera des Mobiltelefons oder sonstigen mobilen elektronischen Endgeräts beinhalten. Das mobile elektronische Endgerät steht dann gegebenenfalls in einer Kommunikationsverbindung mit dem Akkupack und/oder dem externen Computersystem. Beispielsweise kann das elektronische Endgerät den gelesenen Code an das Akkupack übermitteln, direkt oder indirekt, und das Akkupack kann die Konfigurationsinformationen dementsprechend anfordern. Analog kann auch das RFID-Lesegerät in manchen Ausführungsformen extern zu dem Akkupack vorgesehen werden, beispielsweise in dem mobilen elektronischen Endgerät.

Gemäß zumindest einer Ausführungsform wird mittels des Akkupacks, insbesondere mittels des Verarbeitungsschaltkreises über die zweite Kommunikationsschnittstelle, ein digitaler Code über eine elektrische Verbindung des Akkupacks mit dem ersten Elektrogerät erhalten und die Identifikationsinformationen werden basierend auf dem digitalen Code bestimmt, insbesondere mittels des Verarbeitungsschaltkreises.

Dabei wird das Akkupack insbesondere vor Erhalt des digitalen Codes mit dem ersten Elektrogerät mechanisch und elektrisch verbunden. Bei dem digitalen Code handelt es sich insbesondere um einen Bit-Code, also etwa eine Bit-Folge, die mittels einer digitalen Signalübertragung von dem Elektrogerät gesendet und über die zweite Kommunikationsschnittstelle von dem Akkupack erhalten und an den Verarbeitungsschaltkreis übermittelt werden kann.

Das digitale Signal beziehungsweise der digitale Code kann dabei insbesondere drahtgebunden über entsprechende elektrische Kontakte der zweiten Kommunikationsschnittstelle oder drahtlos übermittelt werden. Auf diese Weise kann die zum Erhalten der Identifikationsinformationen erforderliche Hardware auf Seiten des Akkupacks vereinfacht werden.

Gemäß zumindest einer Ausführungsform wird ein Spannungswert und/oder ein Widerstandswert an wenigstens einem elektrischen Kontakt des Akkupacks bestimmt, insbesondere mittels des Verarbeitungsschaltkreises, beispielsweise über die zweite Kommunikationsschnittstelle, während das Akkupack, insbesondere über den wenigstens einen elektrischen Kontakt, elektrisch mit dem ersten Elektrogerät verbunden ist. Die Identifikationsinformationen werden basierend auf dem Spannungswert und/oder dem Widerstandswert bestimmt, insbesondere mittels des Verarbeitungsschaltkreises.

So kann eine besonders einfache Bestimmung der Identifikationsinformationen realisiert werden.

Beispielsweise kann die zweite Kommunikationsschnittstelle als Universal-Asynchron-Receiver-Transmitter-Schnittstelle, UART-Schnittstelle, ausgestaltet sein.

Eine solche Ausführung ist aufgrund der geringen Komplexität von UART-Schnittstellen und aufgrund dessen, dass zum Datenaustausch lediglich zwei Kommunikationsleitungen erforderlich sind, besonders vorteilhaft.

In alternativen Ausführungsformen kann die zweite Kommunikationsschnittstelle auch als I²C-Schnittstelle (englisch: "Inter-Integrated Circuit") ausgestaltet sein.

Gemäß zumindest einer Ausführungsform wird auf dem externen Computersystem eine Vielzahl von Datensätzen gespeichert, wobei ein erster Datensatz der Vielzahl von Datensätzen die Konfigurationsinformationen enthält und wenigstens ein zweiter Datensatz der Vielzahl von Datensätzen jeweilige weitere Konfigurationsinformationen für das wenigstens eine zweite Elektrogerät enthält. In Reaktion auf die Anforderung der Konfigurationsinformationen, insbesondere durch das Akkupack, wird mittels des externen Computersystems der erste Datensatz abhängig von den Identifikationsinformationen aus der Vielzahl von Datensätzen ausgewählt und an das Akkupack übermittelt.

Auf diese Weise erhält also das Akkupack die Konfigurationsinformationen abhängig von den Identifikationsinformationen beziehungsweise in Reaktion auf die Anforderung.

In der Anforderung der Konfigurationsinformationen ist deren Inhalt insbesondere durch das Akkupack noch nicht festgelegt. Die Anforderung der Konfigurationsinformationen kann vielmehr derart verstanden werden, dass das Akkupack anhand der Identifikationsinformationen für das erste Elektrogerät geeignete Konfigurationsinformationen anfordert und das externe Computersystem diese dann wie beschrieben auswählt und übermittelt.

Auf diese Weise kann also eine Vielzahl von Datensätzen für unterschiedliche Elektrogeräte vorgehalten werden und das Akkupack beziehungsweise die Software kann konkret angepasst an die spezifischen Erfordernisse des ersten Elektrogeräts konfiguriert werden. Auf diese Weise ist es insbesondere auch möglich, dass das konfigurierte Akkupack zunächst wie beschrieben mit dem ersten Elektrogerät verwendet wird und zu einem späteren Zeitpunkt mit einem des wenigstens zweiten Elektrogeräts. Hierzu kann dann das Akkupack erneut Konfigurationsinformationen basierend auf weiteren Identifikationsinformationen, welche das zweite Elektrogerät identifizieren, anfordern und von dem externen Computersystem erhalten und die Konfiguration der Software dementsprechend anpassen.

Alternativ können mehrere Softwaremodule auf dem Akkupack vorgehalten werden, die entsprechend unterschiedlicher Konfigurationsinformationen konfiguriert werden, sodass das Akkupack für unterschiedliche Elektrogeräte, beispielsweise das erste Elektrogerät und das zweite Elektrogerät, verwendbar sind, ohne erneut entsprechende Konfigurationsinformationen von dem externen Computersystem abrufen zu müssen.

Gemäß zumindest einer Ausführungsform wird ein vordefinierter erster Steuerungsvorgang zur Steuerung des ersten Elektrogeräts angefordert, die Anforderung des ersten Steuerungsvorgangs wird mittels des Akkupacks erfasst und das erste Elektrogerät wird mittels des Akkupacks abhängig von den Konfigurationsinformationen oder durch die Ausführung der konfigurierten Software zur Durchführung des ersten Steuerungsvorgangs angesteuert.

Die Anforderung des ersten Steuerungsvorgangs kann dabei manuell, insbesondere direkt oder indirekt, oder automatisch erfolgen. Bei einer manuellen Anforderung kann beispielsweise eine Benutzereingabe an dem ersten Elektrogerät, an dem Akkupack oder dem mobilen elektronischen Endgerät vorgenommen werden. Die manuelle Anforderung kann auch indirekt erfolgen, indem ein Benutzer das erste Elektrogerät bestimmungsgemäß verwendet, beispielsweise durch Betätigung eines Eingabeelements zur Aktivierung des elektrischen Verbrauchers. Alternativ oder zusätzlich kann die Anforderung auch automatisiert, beispielsweise abhängig von einem aktuellen Projekt oder Projektstatus, erfolgen.

Die Konfigurationsinformationen oder ein Teil der Konfigurationsinformationen definieren also insbesondere, wie das Akkupack das erste Elektrogerät steuern muss, sodass das erste Elektrogerät den ersten Steuerungsvorgang durchführt oder durchführen kann.

Der erste Steuerungsvorgang kann dabei einem bestimmten Betriebsmodus des ersten Elektrogeräts, beispielsweise bei bestimmten definierten Bedingungen, wie etwa einer konstanten Drehzahl des Motors oder einem konstanten Drehmoment des Motors oder einem bestimmten Drehzahl- oder Drehmomentprofil des Motors und so weiter oder einem konstanten Betriebsstrom und so weiter entsprechen. Solche relativ einfachen Betriebsmodi oder Betriebsbedingungen können auch als generische Steuerungsvorgänge, GCO (englisch: "generic control operation"), bezeichnet werden. Der erste Steuerungsvorgang kann aber auch komplexerer Natur sein, insbesondere zwei oder mehr GCOs oder sonstige vordefinierte Abläufe oder Funktionen spezifizieren.

Gemäß zumindest einer Ausführungsform wird ein zweiter Steuerungsvorgang zur Steuerung des Akkupacks angefordert, die Anforderung des zweiten Steuerungsvorgangs wird mittels des Akkupacks erfasst und der zweite Steuerungsvorgang wird mittels des Akkupacks abhängig von den Konfigurationsinformationen oder durch die Ausführung der konfigurierten Software durchgeführt.

Der zweite Steuerungsvorgang hat dabei insbesondere auch Auswirkungen auf das erste Elektrogerät, sodass auch die Durchführung des zweiten Steuerungsvorgangs wenigstens indirekt eine Steuerung des ersten Elektrogeräts darstellt. Der zweite Steuerungsvorgang kann beispielsweise einer bestimmten Konfiguration oder einem bestimmten Modus einer PWM-Steuerung der Strom- oder Leistungsabgabe durch das Akkupack entsprechen.

Bezüglich der Anforderung des zweiten Steuerungsvorgangs und den Eigenschaften des zweiten Steuerungsvorgangs wird auf die Ausführungen zum ersten Steuerungsvorgang analog verwiesen.

Gemäß zumindest einer Ausführungsform wird, insbesondere mittels des Akkupacks, eine Benutzereingabe erkannt und die Anforderung des ersten Steuerungsvorgangs und/oder des zweiten Steuerungsvorgangs wird abhängig von der Benutzereingabe erfasst.

Die Benutzereingabe kann dabei wie oben bereits angedeutet an dem ersten Elektrogerät, an dem Akkupack, an einem mobilen elektronischen Endgerät, wie etwa einem Smartphone, an einem stationären Rechengerät, etwa einem PC, beispielsweise über eine Webapplikation oder eine Webbrowserapplikation, erfolgen.

Erfolgt die Benutzereingabe nicht direkt am Akkupack, so können beispielsweise entsprechende Sensordaten oder Sensorsignale betreffen die Eingabe am ersten Elektrogerät an das Akkupack beziehungsweise den Verarbeitungsschaltkreis übermittelt werden oder entsprechende Informationen betreffend die Benutzereingabe können von dem mobilen elektronischen Endgerät, der stationären Recheneinheit oder dem externen Computersystem an das Akkupack, insbesondere drahtlos, übermittelt werden.

Die Benutzereingabe kann an dem ersten Elektrogerät beispielsweise über einen Starthebel oder Startknopf zur Bedienung des Elektrogeräts erfolgen oder über einen spezifischen Taster oder ein sonstiges Eingabeelement des ersten Elektrogeräts oder des Akkupacks. Die Benutzereingabe kann auch über eine Spracheingabe über ein Mikrofon des Elektrogeräts oder des Akkupacks oder des mobilen elektronischen Endgeräts und so weiter erfolgen.

Gemäß zumindest einer Ausführungsform wird abhängig von der Benutzereingabe ein aktueller Projektschritt eines durchzuführenden Projekts bestimmt, insbesondere mittels des Verarbeitungsschaltkreises oder mittels des externen Computersystems oder mittels des mobilen elektronischen Endgeräts, und der erste Steuerungsvorgang und/oder der zweite Steuerungsvorgang wird abhängig von dem aktuellen Projektschritt angefordert.

Das Projekt kann beispielsweise eine Sequenz von Projektschritten aufweisen, wobei beispielsweise wenigstens ein Teil der Projektschritte unter Verwendung des mit dem Akkupack betreibbaren ersten Elektrogeräts durchgeführt werden kann. In verschiedenen Projektschritten können auch verschiedene Elektrogeräte einsetzbar sein. Die Sequenz von Projektschritten definiert beispielsweise eine Reihenfolge der individuellen Projektschritte. Die Reihenfolge der Projektschritte ist beispielsweise erforderlich oder vorteilhaft, um das gewünschte Projekt durchführen zu können. Ein Projektschritt kann dabei eine oder mehrere Tätigkeiten, die durch den Benutzer durchzuführen sind, beinhalten. Benutzerinformationen für einen oder mehrere Projektschritte können in einem Datenspeicher des Akkupacks, des Elektrogeräts und/oder des externen Computersystems gespeichert sein. Die Benutzerinformationen beschreiben zum Beispiel eine oder mehrere Tätigkeiten und/oder eine Bezeichnung des jeweiligen Projektschritts und/oder ein einzusetzendes Elektrogerät und/oder ein einzusetzendes sonstiges Zubehör und/oder Material oder dergleichen. Beispielsweise können die Benutzerinformation Informationen betreffend eines oder mehrere Erfordernisse oder Empfehlungen zur Durchführung des jeweiligen Projektschritts beinhalten, wie etwa Informationen betreffend eine Werkzeugauswahl oder Werkzeugkonfiguration. Alternativ oder zusätzlich können die Benutzerinformation auch Informationen zu Größen, Maßen, Formbemaßungen, Lagebemaßungen, Materialparametern und so weiter beinhalten. Die Benutzerinformationen können auch Informationen betreffend die entsprechende Reihenfolge der Projektschritte innerhalb der Sequenz beinhalten.

Es kann beispielsweise ein aktueller Projektstatus bestimmt werden und der aktuelle Projektschritt kann abhängig von dem aktuellen Projektstatus bestimmt werden. Der Projektstatus entspricht dabei insbesondere der Information, welche Projektschritte der Sequenz von Projektschritten bereits vergangen oder erledigt sind beziehungsweise welche noch bevorstehen beziehungsweise welcher der aktuelle oder unmittelbar bevorstehende Projektschritt ist. Diese Information kann beispielsweise der Verarbeitungsschaltkreis basierend auf einem vorgegebenen Zeitplan, basierend auf einer Benutzereingabe und/oder auf Messungen von Betriebsparametern des ersten Elektrogeräts oder des Akkupacks bestimmen.

Gemäß zumindest einer Ausführungsform wird mittels des Akkupacks ein Betriebsstrom zum Betrieb des elektrischen oder elektronischen Verbrauchers des ersten Elektrogeräts und/oder eine Betriebsspannung zum Betrieb des Verbrauchers und/oder eine Leistungsabgabe einer Energiequelle des Akkupacks, insbesondere der wenigstens einen Akkumulatorzelle, an den Verbraucher überwacht. Der aktuelle Projektschritt des durchzuführenden Projekts wird abhängig von einem Ergebnis der Überwachung bestimmt und der erste Steuerungsvorgang und/oder der zweite Steuerungsvorgang werden abhängig von dem aktuellen Projektschritt angefordert.

Gemäß zumindest einer Ausführungsform wird mittels des Akkupacks eine Statusinformation mittels drahtloser Kommunikation erhalten und der aktuelle Projektschritt des durchzuführenden Projekts wird abhängig von der Statusinformation bestimmt. Der erste Steuerungsvorgang und/oder der zweite Steuerungsvorgang werden abhängig von dem aktuellen Projektschritt angefordert.

Gemäß zumindest einer Ausführungsform wird ein vordefinierter dritter Steuerungsvorgang zur Steuerung eines dritten Elektrogeräts angefordert und die Anforderung des dritten Steuerungsvorgangs wird mittels des Akkupacks erfasst. Abhängig von den Konfigurationsinformationen beziehungsweise durch Ausführung der konfigurierten Software wird eine Nachricht von dem Akkupack an das dritte Elektrogerät übermittelt, insbesondere drahtlos oder drahtgebunden. Der dritte Steuerungsvorgang wird mittels des dritten Elektrogeräts abhängig von der übermittelten Nachricht durchgeführt.

Die Anforderung des dritten Steuerungsvorgangs kann dabei beispielsweise basierend auf Sensordaten eines oder mehrerer Sensoren des ersten Elektrogeräts und/oder des Akkupacks durchgeführt werden.

Auf diese Weise kann ein gekoppelter Betrieb des ersten und des dritten Elektrogeräts erreicht werden. Die Kommunikation beziehungsweise die Kopplung des ersten und des dritten Elektrogeräts wird dabei ebenfalls durch die Konfigurationsinformationen festgelegt.

Die Übermittlung der Nachricht von dem Akkupack an das dritte Elektrogerät kann dabei direkt, insbesondere direkt und drahtlos, von dem Akkupack an das dritte Elektrogerät erfolgen oder indirekt, indem das Akkupack die Nachricht beispielsweise an das externe Computersystem übermittelt und das externe Computersystem die Nachricht an das dritte Elektrogerät übermittelt.

Das dritte Elektrogerät kann dabei beispielsweise ein weiteres Akkupack zur Energieversorgung des dritten Elektrogeräts beinhalten. Die Kommunikation des dritten Elektrogeräts mit dem Akkupack und/oder mit dem externen Computersystem kann dann in manchen Ausführungsformen teilweise oder vollständig durch das weitere Akkupack des dritten Elektrogeräts realisiert werden. Beispielweise kann ein aktiver Betriebsmodus des dritten Elektrogeräts aktiviert oder verändert werden, wenn das erste aktiviert wird.

Gemäß zumindest einer Ausführungsform wird der dritte Steuerungsvorgang abhängig von einer Aktivierung des ersten Elektrogeräts, insbesondere einer Aktivierung des elektrischen oder elektronischen Verbrauchers des ersten Elektrogeräts, angefordert.

Das erste Elektrogerät beziehungsweise der Verbraucher wird also aktiviert, die Aktivierung wird detektiert, insbesondere durch einen oder mehrere Sensoren des ersten Elektrogeräts und/oder des Akkupacks, und basierend darauf beziehungsweise in Reaktion darauf wird der dritte Steuerungsvorgang angefordert.

Die Koppelung des ersten und des dritten Elektrogeräts kann auf verschiedene Weisen realisiert werden. Beispielsweise kann das dritte Elektrogerät immer dann, beispielsweise nur dann, aktiviert werden, wenn auch das erste Elektrogerät aktiviert wird. Andererseits kann das dritte Elektrogerät auch deaktiviert werden, wenn das erste Elektrogerät aktiviert wird oder ein Betriebsmodus des dritten Elektrogeräts kann abhängig von der Aktivierung des ersten Elektrogeräts auf andere Art verändert werden.

Gemäß einem weiteren Aspekt der Erfindung wird ein Akkupack angegeben, das, insbesondere zur Energieversorgung, wahlweise mit einem ersten Elektrogerät und wenigstens einem zweiten Elektrogerät, insbesondere elektrisch und/oder mechanisch, verbindbar ist. Das Akkupack weist ein Speicherelement auf, das eine generische Software zur Steuerung des ersten Elektrogeräts und des wenigstens einen zweiten Elektrogeräts speichert. Das Akkupack weist einen Verarbeitungsschaltkreis auf, der dazu eingerichtet ist, Identifikationsinformationen, welche das Elektrogerät identifizieren, zu erhalten. Das Akkupack weist eine Kommunikationsschnittstelle, insbesondere eine erste Kommunikationsschnittstelle, auf, die zum drahtlosen Datenaustausch mit einem externen Computersystem eingerichtet ist. Der Verarbeitungsschaltkreis ist dazu eingerichtet, abhängig von den Identifikationsinformationen über die Kommunikationsschnittstelle Konfigurationsinformationen drahtlos von dem externen Computersystem anzufordern und zu erhalten. Der Verarbeitungsschaltkreis ist dazu eingerichtet, die Software gemäß den erhaltenen Konfigurationsinformationen zu konfigurieren und das erste Elektrogerät durch Ausführung der konfigurierten Software zu steuern.

Weitere Ausführungsformen des erfindungsgemäßen Akkupacks folgen unmittelbar aus den verschiedenen Ausgestaltungen des erfindungsgemäßen Verfahrens und umgekehrt. Insbesondere lassen sich einzelne Merkmale und entsprechende Erläuterungen bezüglich der verschiedenen Ausführungsformen zu dem erfindungsgemäßen Verfahren analog auf entsprechende Ausführungsformen des erfindungsgemäßen Akkupacks übertragen. Insbesondere ist das erfindungsgemäße Akkupack zum Durchführen eines erfindungsgemäßen Verfahrens ausgebildet oder programmiert. Insbesondere führt das erfindungsgemäße Akkupack das erfindungsgemäße Verfahren durch.

Weitere Merkmale der Erfindung ergeben sich aus den Ansprüchen, den Figuren und der Figurenbeschreibung. Die vorstehend in der Beschreibung genannten Merkmale und Merkmalskombinationen sowie die nachfolgend in der Figurenbeschreibung genannten und/oder in den Figuren gezeigten Merkmale und Merkmalskombinationen können nicht nur in der jeweils angegebenen Kombination, sondern auch in anderen Kombinationen von der Erfindung umfasst sein. Es können insbesondere auch Ausführungen und Merkmalskombinationen von der Erfindung umfasst sein, die nicht alle Merkmale eines ursprünglich formulierten Anspruchs aufweisen. Es können darüber hinaus Ausführungen und Merkmalskombinationen von der Erfindung umfasst, die über die in den Rückbezügen der Ansprüche dargelegten Merkmalskombinationen hinausgehen oder von diesen abweichen.

Die Erfindung wird im Folgenden anhand konkreter Ausführungsbeispiele und zugehöriger schematischer Zeichnungen näher erläutert. In den Figuren können gleiche oder funktionsgleiche Elemente mit denselben Bezugszeichen versehen sein. Die Beschreibung gleicher oder funktionsgleicher Elemente wird gegebenenfalls nicht notwendigerweise bezüglich verschiedener Figuren wiederholt.

In den Figuren zeigen:
- Fig. 1: eine schematische Darstellung einer beispielhaften Ausführungsform eines erfindungsgemäßen Akkupacks;
- Fig. 2: eine schematische Darstellung einer weiteren beispielhaften Ausführungsform eines erfindungsgemäßen Akkupacks; und
- Fig. 3: eine schematische Darstellung einer weiteren beispielhaften Ausführungsform eines erfindungsgemäßen Akkupacks.

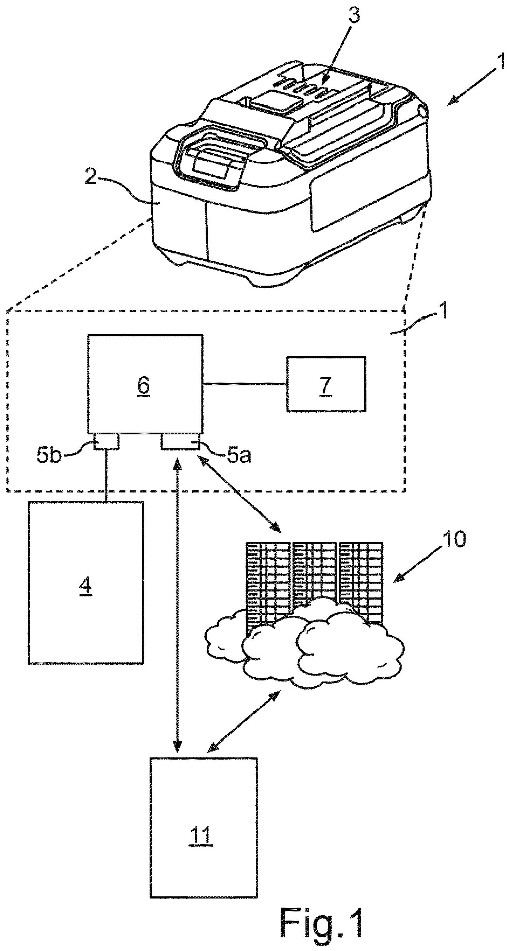

In Fig. 1 ist schematisch eine beispielhafte Ausführungsform eines erfindungsgemäßen Akkupacks 1 dargestellt, das elektrisch und mechanisch mit einem Elektrogerät 4, beispielsweise einem Elektrowerkzeug, zur Energieversorgung des Elektrogerät 4, beispielsweise eines Elektromotors des Elektrogeräts 4, verbunden werden kann. Ferner ist ein externes Computersystem 10 dargestellt.

Das Akkupack 1 ist ein generisches Akkupack, auch als System- oder Wechselakkupack bezeichnet, das anstatt mit dem Elektrogerät 4 mit weiteren Elektrogeräten (nicht dargestellt) zu deren Energieversorgung verbunden werden kann. Die weiteren Elektrogeräte sind dabei nicht notwendigerweise vom selben Typ wie das Elektrogerät 4.

Das Akkupack 1 weist ein Speicherelement (nicht dargestellt) auf, das eine generische Software zur wahlweisen Steuerung des Elektrogeräts 4 und der weiteren Elektrogeräte speichert, wobei eine Steuerung des Elektrogeräts 4 oder der weiteren Elektrogeräte insbesondere eine spezifische Konfiguration der zunächst generischen Software erfordert.

Das Akkupack 1 weist insbesondere ein Gehäuse 2 und eine Schnittstelle 3 zur mechanischen und elektrischen Verbindung des Gehäuses 2 beziehungsweise des Akkupacks 1 an einem entsprechenden Gehäuse (nicht dargestellt) des Elektrogeräts 4 auf.

Das Akkupack 1 weist einen Verarbeitungsschaltkreis 6 sowie eine erste Kommunikationsschnittstelle 5a zur drahtlosen Kommunikation mit dem externen Computersystem 10 auf. Das Akkupack 1 weist außerdem eine zweite Kommunikationsschnittstelle 5b zur drahtlosen oder drahtgebundenen Kommunikation mit dem Elektrogerät 4 auf. Die Schnittstelle 3 kann einen Teil der zweiten Kommunikationsschnittstelle 5b darstellen oder zusätzlich zu der zweiten Kommunikationsschnittstelle 5b vorgesehen sein.

Das Akkupack 1 weist außerdem einen elektrischen Energiespeicher 7, insbesondere eine oder mehrere in Reihe und/oder parallel zueinander verschaltete Akkumulatorzellen, zur Energieversorgung des Elektrogeräts 4 und insbesondere auch zur Energieversorgung sämtlicher elektronischer Komponenten des Akkupacks 1 selbst auf.

Der Verarbeitungsschaltkreis 6 kann, beispielsweise über die zweite Kommunikationsschnittstelle 5b, etwa in Form eines digitalen Codes, Identifikationsinformationen betreffend das Elektrogerät 4 erhalten. Der Verarbeitungsschaltkreis 6 kann dann abhängig von den Identifikationsinformationen über die erste Kommunikationsschnittstelle 5a Konfigurationsinformationen von dem externen Computersystem 10 anfordern und als Reaktion darauf von dem externen Computersystem 10 erhalten.

Der Verarbeitungsschaltkreis 6, insbesondere ein Softwaremodul (nicht dargestellt) des Verarbeitungsschaltkreises 6, ist dazu eingerichtet, die zunächst generische Software gemäß den Konfigurationsinformationen zu konfigurieren. Sodann kann der Verarbeitungsschaltkreis 6 die konfigurierte Software, also insbesondere wenigstens einen Teil der konfigurierten Software, ausführen und dadurch und das erste Elektrogerät 4 steuern.

In manchen Ausführungsformen kann eine Benutzereingabe erfasst werden, beispielsweise über eine Benutzerschnittstelle des externen Computersystems 10, und abhängig von der Benutzereingabe können die Konfigurationsinformationen für die Software betreffend die Steuerung des Elektrogeräts 4 durch das Akkupack 1 bestimmt werden, beispielsweise mittels des externen Computersystems 10.

Der Benutzer, etwa ein Entwickler, kann die Konfigurationsinformationen dementsprechend spezifisch für das Elektrogerät 4 festlegen, ohne dass eine vollständige Programmierung der Software erforderlich ist.

Die Steuerung des Elektrogeräts 4 durch Ausführung der Software kann insbesondere eine oder mehrere vordefinierte und anhand der Konfigurationsinformationen spezifizierte, konfigurierte oder parametrierte Steuerungsvorgänge beinhalten. Diese Steuerungsvorgänge können relativ einfache Routinen oder Betriebsmodi des Elektrogeräts 4 und/oder des Akkupacks 1 darstellen, die zum Beispiel als GCOs (englisch: "generic control operation") bezeichnet werden können. Mögliche Beispiele für GCOs sind etwa eine Versorgung des Elektrogeräts 4 und durch das Akkupack 1 mit einem konstanten Strom oder einer konstanten elektrischen Leistung, beispielsweise über PWM-Steuerung, den Betrieb des Elektromotors des Elektrogeräts 4 mit einer konstanten Drehzahl oder einem konstanten Drehmoment und so weiter. Eine GCO kann auch eine vordefinierte Verknüpfung zweier oder mehrere Betriebsparameter miteinander realisieren, etwa eine vordefinierte Beziehung zwischen Motordrehzahl und Motordrehmoment, zwischen Motordrehzahl und abgegebener Leistung, und so weiter.

Eine GCO kann auch ein vorgegebenes dynamisches Profil eines oder mehrerer Betriebsparameter, beispielsweise Motordrehzahl, Motordrehmoment, abgegebene Leistung und so weiter, definieren, etwa im Rahmen eines Startvorgangs beim Aktivieren des Elektromotors des Elektrogeräts 4 oder dergleichen. Solche Startvorgänge können beispielsweise durch sogenannte Soft-Start Profile definiert sein, sodass ein bestimmter Betriebsparameter beispielsweise nicht sofort auf einen Zielwert eingestellt wird, wenn das Elektrogerät 4 aktiviert wird, sondern zum Beispiel ein kontinuierlicher Verlauf des Betriebsparameters, etwa der Motordrehzahl, des Motordrehmoments, der abgegebenen Leistung und so weiter, erreicht wird.

Darüber hinaus können die Steuerungsvorgänge auch komplexere Betriebsmodi oder Betriebsprofile umsetzen, etwa durch Kombination zweier oder mehrerer GCOs. So können beispielsweise konkrete Aufgaben oder Tätigkeiten, die ein Benutzer mit dem Elektrogerät 4 durchführen möchte kontrolliert beziehungsweise optimiert durchgeführt werden. Ist das Elektrogerät 4 beispielsweise als Schrauber ausgestaltet und soll eine bestimmte Art von Schraube damit eingeschraubt werden, so kann ein entsprechender Steuerungsvorgang beispielsweise ein Soft-Start Profil gefolgt von einem Betrieb mit konstanter Drehzahl über eine bestimmte Zeitdauer und/oder Anzahl von Umdrehungen kombinieren. Danach kann beispielsweise die Drehzahl reduziert werden und ein vorgegebenes Drehmoment eingestellt werden. Hierbei handelt es sich jedoch lediglich um ein nicht beschränkendes Beispiel.

Um solche und weitere Steuerungsvorgänge steuern zu können, benötigt die Software detaillierte Informationen, Parameterwerte, Parametergrenzen und so weiter für die einzelnen Steuerungsvorgänge, angepasst an das konkrete Elektrogerät 4. Diese Informationen können in Form der Konfigurationsinformationen individuell und flexibel bereitgestellt werden.

In manchen Ausführungsformen kann das Akkupack 1, insbesondere der Verarbeitungsschaltkreis 6, beispielsweise über die erste Kommunikationsschnittstelle 5a oder eine weitere Kommunikationsschnittstelle (nicht dargestellt) mit einem weiteren Elektrogerät 11 oder einem weiteren Akkupack (nicht dargestellt) des weiteren Elektrogeräts 11 kommunizieren. Diese Kommunikation kann direkt erfolgen oder indirekt über das externe Computersystem 10.

Auf diese Weise kann zum Beispiel ein gekoppelter Betrieb des Elektrogeräts 4 mit dem weiteren Elektrogerät 11 umgesetzt werden. Die Kopplung kann auf verschiedenste Arten erfolgen. Beispielsweise kann das Elektrogerät 11, etwa eine Absauganlage oder eine Leuchte, genau dann aktiviert werden, wenn das Elektrogerät 4, etwa eine Säge, aktiviert wird. Alternativ kann das Elektrogerät 11, beispielsweise ein Rasenmäher, deaktiviert werden, wenn das Elektrogerät 4, etwa eine Bewässerungsanlage, aktiviert wird. Vielfältige weitere Möglichkeiten sind, je nach Ausgestaltung des Elektrogeräts 4 und des weiteren Elektrogeräts 11, denkbar.

Zur Kommunikation des Elektrogeräts 4 mit dem weiteren Elektrogerät 11 kann ebenfalls eine entsprechende Konfiguration des Akkupacks 1 beziehungsweise der Software erforderlich sein. Auch dies kann anhand der Konfigurationsinformationen realisiert werden. Die Steuerungsvorgänge können dann dementsprechend auch die Kommunikation des Elektrogeräts 4 mit dem weiteren Elektrogerät 11 betreffen oder spezifizieren.

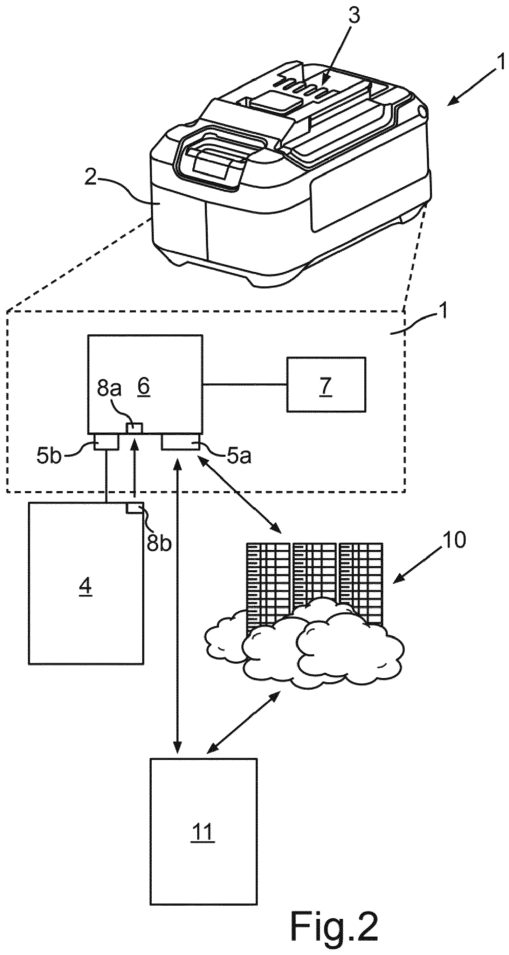

In der Fig. 2 ist eine weitere beispielhafte Ausführungsform des Akkupacks 1 schematisch dargestellt. Das Akkupack 1 basiert auf dem bezüglich Fig. 1 beschriebenen Akkupack 1, wobei die Identifikationsinformationen hier von einem RFID-Lesegerät 8a des Akkupacks 1 aus einem RFID-Transponder 8b des Elektrogeräts 4 ausgelesen werden.

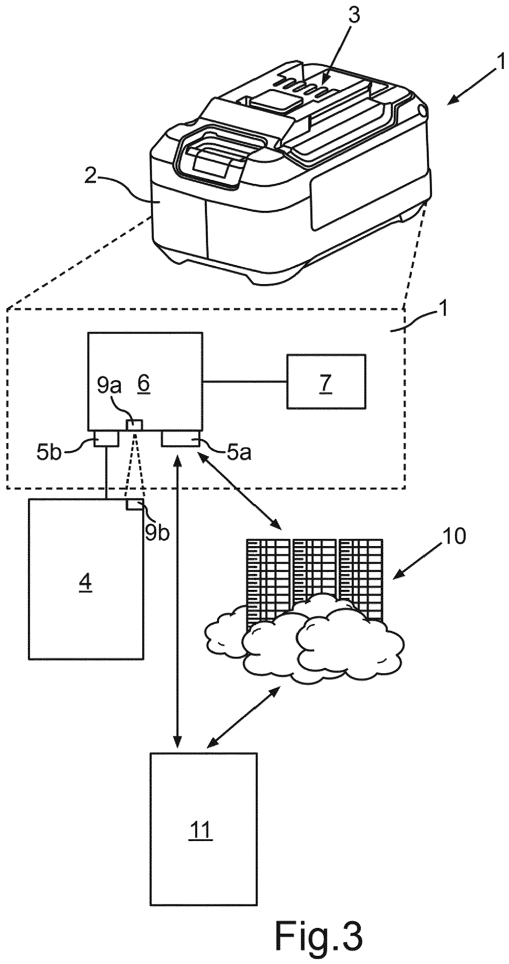

In der Fig. 3 ist eine weitere beispielhafte Ausführungsform des Akkupacks 1 schematisch dargestellt, welche auf der Ausführungsform der Fig. 1 beruht.

Hier weist das Akkupack 1 ein optisches Lesegerät 9a auf, beispielsweise einen Barcode-Scanner, der einen entsprechenden visuell lesbaren Code 9b des Elektrogeräts 4 lesen kann und den gelesenen Code an den Verarbeitungsschaltkreis 6 übermitteln kann, um die Identifikationsinformationen, die in dem gelesenen Code enthalten sind, bereitzustellen.

Wie insbesondere anhand der Figuren erläutert wurde, erlaubt die Erfindung einen universellen und flexiblen Einsatz eines Akkupacks, das grundsätzlich für verschiedene Elektrogeräte geeignet ist, und gleichzeitig eine gezielte Steuerung eines individuellen Elektrogeräts durch das Akkupack entsprechend den konkreten Möglichkeiten, Erfordernissen und Eigenschaften des individuellen Elektrogeräts.

In bevorzugten Ausführungsformen kommuniziert das Akkupack über eine UART-Schnittstelle oder eine I²C-Schnittstelle mit dem Elektrogerät und erhält die Konfigurationsinformationen drahtlos aus einer Cloud.

Beispielsweise kann zunächst eine generische Firmware zur Steuerung verschiedener Elektrogeräte auf dem Akkupack gespeichert werden. Beispielsweise kann ein Satz von Parametern anhand einer Benutzerabfrage über eine Cloud-Applikation erfasst und dementsprechende Konfigurationsinformationen an das Akkupack übertragen werden. Dieses kann dann die Firmware dementsprechend konfigurieren beziehungsweise parametrieren, sodass das Akkupack definierte GCOs oder komplexere Steuerungsvorgänge initiieren und steuern kann.

Die Firmware kann dann von Sensoren des Akkupacks und oder des individuellen Elektrogeräts, etwa Stromsensoren, Spannungssensoren, Temperatursensoren, und so weiter, Messwerte oder sonstige Signale oder Informationen entgegennehmen, diese gegebenenfalls verarbeiten und/oder zur Durchführung von Steuerungsvorgängen verwenden oder bereitstellen. Ferner kann die Firmware gegebenenfalls Aktuatoren des Akkupacks, etwa Leistungstransistoren zur PWM-Steuerung des abgegebenen Stroms und dergleichen, ansteuern. Die Firmware kann unter Umständen auch erforderliche Befehlssätze entgegennehmen und geeignet weiterreichen oder umsetzen.

Die einzelnen GCOs oder komplexeren Steuerungsvorgänge können manuell durch eine Benutzereingabe und/ oder cloudgesteuert und/oder automatisch beispielsweise projektabhängig angefordert und durchgeführt werden.

### BEZUGSZEICHENLISTE:

- 1: Akkupack
- 2: Gehäuse
- 3: Schnittstelle
- 4: Elektrogerät
- 5a: Kommunikationsschnittstelle
- 5b: Kommunikationsschnittstelle
- 6: Verarbeitungsschaltkreis
- 7: Energiespeicher
- 8a: RFID-Lesegerät
- 8b: RFID-Transponder
- 9a: optisches Lesegerät
- 9b: visuell lesbarer Code
- 10: externes Computersystem
- 11: Elektrogerät

## Patentansprüche

1. Verfahren zur Steuerung eines ersten Elektrogeräts (4) mittels eines Akkupacks (1), das wahlweise mit dem ersten Elektrogerät (4) und wenigstens einem zweiten Elektrogerät verbindbar ist, wobei
- eine generische Software zur Steuerung des ersten Elektrogeräts (4) und des wenigstens einen zweiten Elektrogeräts auf einem Speicherelement des Akkupacks (1) gespeichert wird;
- Identifikationsinformationen, welche das erste Elektrogerät (4) identifizieren, von dem Akkupack (1) erhalten werden;
- abhängig von den Identifikationsinformationen mittels des Akkupacks (1) Konfigurationsinformationen von einem externen Computersystem (10) angefordert und erhalten werden;
- die Software gemäß den Konfigurationsinformationen konfiguriert wird; und
- das erste Elektrogerät (4) mittels des Akkupacks (1) durch Ausführung der konfigurierten Software gesteuert wird.

2. Verfahren nach Anspruch 1, wobei
- das erste Elektrogerät (4) in einem Erfassungsbereich eines Lesegeräts (8a, 9a) positioniert wird; und
- die Identifikationsinformationen mittels des Lesegeräts (8a, 9a) erfasst werden.

3. Verfahren nach Anspruch 2, wobei die Identifikationsinformationen mittels des Lesegeräts (8a) per Radiofrequenz-Identifikation, RFID, von einem RFID-Transponder (8b) des ersten Elektrogeräts (4) erhalten werden.

4. Verfahren nach Anspruch 2, wobei mittels des Lesegeräts (9a) ein visuell lesbarer Code (9b) des ersten Elektrogeräts (4) gelesen wird und die Identifikationsinformationen basierend auf dem gelesenen visuell lesbaren Code (9b) bestimmt werden.

5. Verfahren nach Anspruch 1, wobei mittels des Akkupacks (1) ein digitaler Code über eine Verbindung des Akkupacks (1) mit dem ersten Elektrogerät (4) erhalten wird und die Identifikationsinformationen basierend auf dem digitalen Code bestimmt werden.

6. Verfahren nach Anspruch 1, wobei
- ein Spannungswert und/oder einen Widerstandswert an wenigstens einem elektrischen Kontakt des Akkupacks (1) bestimmt wird, während das Akkupack (1) elektrisch mit dem ersten Elektrogerät (4) verbunden ist; und
- die Identifikationsinformationen basierend auf dem Spannungswert und/oder dem Widerstandswert bestimmt werden.

7. Verfahren nach einem der vorhergehenden Ansprüche, wobei
- auf dem externen Computersystem (10) eine Vielzahl von Datensätzen gespeichert wird, wobei ein erster Datensatz der Vielzahl von Datensätzen die Konfigurationsinformationen enthält und wenigstens ein zweiter Datensatz der Vielzahl von Datensätzen jeweilige weitere Konfigurationsinformationen für das wenigstens eine zweite Elektrogerät enthält;
- in Reaktion auf die Anforderung der Konfigurationsinformationen mittels des externen Computersystems (10) der erste Datensatz abhängig von den Identifikationsinformationen aus der Vielzahl von Datensätzen ausgewählt und an das Akkupack (1) übermittelt wird.

8. Verfahren nach einem der vorhergehenden Ansprüche, wobei
- ein vordefinierter erster Steuerungsvorgang zur Steuerung des ersten Elektrogeräts (4) angefordert wird, die Anforderung des ersten Steuerungsvorgangs mittels des Akkupacks (1) erfasst wird und das erste Elektrogerät (4) mittels des Akkupacks (1) abhängig von den Konfigurationsinformationen oder durch die Ausführung der konfigurierten Software zur Durchführung des ersten Steuerungsvorgangs angesteuert wird; und/oder
- ein vordefinierter zweiter Steuerungsvorgang zur Steuerung des Akkupacks (1) angefordert wird, die Anforderung des zweiten Steuerungsvorgangs mittels des Akkupacks (1) erfasst wird und der zweite Steuerungsvorgang mittels des Akkupacks (1) abhängig von den Konfigurationsinformationen oder durch die Ausführung der konfigurierten Software durchgeführt wird.

9. Verfahren nach Anspruch 8, wobei eine Benutzereingabe erkannt wird und die Anforderung des ersten Steuerungsvorgangs und/oder des zweiten Steuerungsvorgangs abhängig von der Benutzereingabe erfasst wird.

10. Verfahren nach Anspruch 9, wobei abhängig von der Benutzereingabe ein aktueller Projektschritt eines durchzuführenden Projekts bestimmt wird und der erste Steuerungsvorgang und/oder der zweite Steuerungsvorgang abhängig von dem aktuellen Projektschritt angefordert wird.

11. Verfahren nach Anspruch 8, wobei
- mittels des Akkupacks (1) ein Betriebsstrom zum Betrieb eines elektrischen oder elektronischen Verbrauchers des ersten Elektrogeräts (4) und/oder eine Betriebsspannung zum Betrieb des Verbrauchers und/oder eine Leistungsabgabe einer Energiequelle an den Verbraucher überwacht wird;
- ein aktueller Projektschritt eines durchzuführenden Projekts abhängig von einem Ergebnis der Überwachung bestimmt wird; und
- der erste Steuerungsvorgang und/oder der zweite Steuerungsvorgang abhängig von dem aktuellen Projektschritt angefordert wird.

12. Verfahren nach Anspruch 8, wobei
- mittels des Akkupacks (1) eine Statusinformation mittels drahtloser Kommunikation erhalten wird und ein aktueller Projektschritt eines durchzuführenden Projekts abhängig von der Statusinformation bestimmt wird; und
- der erste Steuerungsvorgang und/oder der zweite Steuerungsvorgang abhängig von dem aktuellen Projektschritt angefordert wird.

13. Verfahren nach einem der vorhergehenden Ansprüche, wobei
- ein vordefinierter dritter Steuerungsvorgang zur Steuerung eines dritten Elektrogeräts (11) angefordert wird und die Anforderung des dritten Steuerungsvorgangs mittels des Akkupacks (1) erfasst wird;
- abhängig von den Konfigurationsinformationen oder durch Ausführung der konfigurierten Software eine Nachricht von dem Akkupack (1) an das dritte Elektrogerät (11) übermittelt wird; und
- der dritte Steuerungsvorgang mittels des dritten Elektrogeräts (11) abhängig von der übermittelten Nachricht durchgeführt wird.

14. Verfahren nach Anspruch 13, wobei der dritte Steuerungsvorgang abhängig von einer Aktivierung des ersten Elektrogeräts angefordert wird.

15. Akkupack (1), das wahlweise mit einem ersten Elektrogerät (4) und wenigstens einem zweiten Elektrogerät verbindbar ist, wobei
- das Akkupack (1) ein Speicherelement aufweist, das eine generische Software zur Steuerung des ersten Elektrogeräts (4) und des wenigstens einen zweiten Elektrogeräts speichert;
- das Akkupack (1) einen Verarbeitungsschaltkreis (6) aufweist, der dazu eingerichtet ist, Identifikationsinformationen, welche das Elektrogerät (4) identifizieren, zu erhalten;
- das Akkupack (1) eine Kommunikationsschnittstelle (5a) aufweist, die zum drahtlosen Datenaustausch mit einem externen Computersystem (10) eingerichtet ist, wobei der Verarbeitungsschaltkreis (6) dazu eingerichtet ist, abhängig von den Identifikationsinformationen über die Kommunikationsschnittstelle (5a) Konfigurationsinformationen drahtlos von dem externen Computersystem (10) anzufordern und zu erhalten;
- der Verarbeitungsschaltkreis (6) dazu eingerichtet ist, die Software gemäß den Konfigurationsinformationen zu konfigurieren und das erste Elektrogerät (4) durch Ausführung der konfigurierten Software zu steuern.
